# EUROPÄISCHE PATENTSCHRIFT

(11) **EP 3 821 264 B1**
(45) Veröffentlichungstag und Bekanntmachung des Hinweises auf die Patenterteilung: **26.02.2025**
(21) Anmeldenummer: 19739594.0
(22) Anmeldetag: 11.07.2019
(51) Int. Cl.: G01R 27/18, G01R 31/08, G01R 31/52

(54) **ERDLEITER-ÜBERWACHUNG**
GROUND CONDUCTOR MONITORING
SURVEILLANCE DE CONDUCTEUR DE TERRE

(30) Priorität: 13.07.2018 DE 202018104044 U
(43) Veröffentlichungstag der Anmeldung: 19.05.2021
(73) Patentinhaber: Wago Verwaltungsgesellschaft mbH, 32423 Minden (DE)
(72) Erfinder: SELLKE, Frank, 32423 Minden (DE); REWALD, Jan, 32369 Rahden (DE)
(74) Vertreter: Kröncke, Rolf
(86) Internationale Anmeldenummer: PCT/EP2019/068727
(87) Internationale Veröffentlichungsnummer: WO 2020/011939

(56) Entgegenhaltungen:
- EP-A1- 2 237 057
- EP-A2- 2 574 939
- DE-A1- 102006 022 686
- US-A1- 2017 138 995

## Beschreibung

Die Erfindung betrifft eine Erdleiter-Überwachungseinrichtung mit den Merkmalen des Anspruchs 1. Die Erfindung betrifft außerdem ein Computerprogramm zur Ausführung eines Verfahrens zur Überwachung eines Erdleiters eines mittels des Erdleiters geerdeten elektrischen Geräts, das mittels eines ersten elektrischen Potenzials, das sich vom Erdleiter-Potenzial unterscheidet, und eines zweiten elektrischen Potenzials, das sich vom ersten Potenzial und vom Erdleiter-Potenzial unterscheidet, elektrische Energie bereitstellt und/oder mit elektrischer Energie versorgt wird.

Beim Betrieb von elektrischen Maschinen und Anlagen stehen die Sicherheit von Personen sowie der sichere Betrieb des elektrischen Geräts an vorderster Stelle. Hierzu werden unter anderem Fehler- und Überstromschutzelemente eingesetzt. Voraussetzung hierfür ist ein Anschluss solcher Maschinen und Anlagen an einen Erdleiter, der auch als Schutzleiter bezeichnet wird, um eine niederohmige Erdung zu erreichen. Die Erfindung betrifft somit das Gebiet der Anschlusstechnik von elektrischen Geräten, die einen Erdleiter-Anschluss (oder Schutzleiteranschluss) aufweisen.

In der Automatisierungstechnik wird beispielsweise ein Netzteil im Schaltschrank zur Erzeugung einer Versorgungsspannung für im Schaltschrank eingebaute elektrische Geräte eingesetzt. Ein solches Netzteil ist üblicherweise über einen Erdleiter-Anschluss mit einem Erdleiter verbunden. In solchen Anwendungen werden die Geräte im Schaltschrank häufig auf einer Tragschiene befestigt. Die Tragschiene wird dabei häufig als Erdleiter genutzt.

Um eine fortlaufende Sicherheit im Betrieb solcher Anlagen zu gewährleisten, ist eine regelmäßige Erdschlussprüfung erforderlich. Hierbei muss geprüft werden, ob ein sogenannter Erdschluss vorliegt, d.h. ein Kurzschluss eines der beiden Versorgungspotentiale des Netzteils zum Erdleiter. Die Versorgungspotentiale des Netzteils können z.B. 0 Volt und Betriebsspannung sein, z.B. 24 Volt Gleichspannung. Für diese Erdschlussprüfungen werden bisher sogenannte Erdleiter-Trennklemmen eingesetzt, die über ein manuell betätigbares Trennmesser verfügen. Mittels des Trennmessers kann die normalerweise vorhandene Verbindung der 0 Volt-Leitung mit dem Erdleiter aufgetrennt werden. Im aufgetrennten Zustand kann dann eine Messung durchgeführt werden, anhand der erkannt werden kann, ob ein Erdschluss vorliegt.

Aus der US 2017/0138995 A1 ist ein Verfahren und ein System zum Überwachen einer elektrischen Isolation bekannt. Aus der EP 2 574 939 A1 ist ein Isolationsfehlersuchgerät und eine Vorrichtung zur Isolationsfehlerlokalisierung in einem ungeerdeten Stromversorgungsnetz bekannt. Aus der EP 2 237 057 A1 ist eine Analysevorrichtung zur Analyse eines Stromnetzes bekannt.

Der Erfindung liegt die Aufgabe zugrunde, den Aufwand für solche Erdschlussprüfungen zu verringern.

Diese Aufgabe wird mittels einer Erdleiter-Überwachungseinrichtung gemäß Anspruch 1 für die Überwachung eines Erdleiters im Sinne eines Schutzleiters, über den ein elektrisches Gerät geerdet ist, gelöst. Die Erdleiter-Überwachungseinrichtung weist folgendes auf:
a) wenigstens einen Erdleiter-Anschluss, der zum Anschluss eines Erdleiter-Potenzials des Erdleiters eingerichtet ist,
b) wenigstens einen ersten Potenzialanschluss, der zum Anschluss eines ersten elektrischen Potenzials eingerichtet ist, das sich vom Erdleiter-Potenzial unterscheidet,
c) wenigstens einen zweiten Potenzialanschluss, der zum Anschluss eines zweiten elektrischen Potenzials eingerichtet ist, das sich vom ersten Potenzial und vom Erdleiter-Potenzial unterscheidet,
d) wenigstens eine elektrische Schalteinrichtung, die dazu eingerichtet ist, wahlweise in Abhängigkeit von einem elektrischen Ansteuersignal eine elektrische Verbindung zwischen dem ersten Potenzialanschluss und dem Erdleiter-Anschluss herzustellen (Verbindungszustand) oder zu unterbrechen (Unterbrechungszustand),
e) wenigstens eine Steuerungseinheit, die dazu eingerichtet ist, automatisch Ansteuersignale an die elektrische Schalteinrichtung abzugeben,
dadurch gekennzeichnet, dass die Auswertung der elektrischen Signale am Erdleiter-Anschluss ohne Messung des Stroms im Erdleiter erfolgt.

Die Erfindung hat den Vorteil, dass die Erdschlussprüfungen nicht mehr manuell durchgeführt werden müssen, sondern zumindest teilweise automatisch mittels der erfindungsgemäßen Erdleiter-Überwachungseinrichtung. Hierdurch wird der personelle Aufwand deutlich verringert. Zudem wird die Sicherheit erhöht, da die automatische Erdschlussprüfung wesentlich öfter durchgeführt werden kann, als dies bei manuellen Prozessen bisher möglich war. Bei der manuellen Überprüfung wurde die Erdschlussprüfung typischerweise im Abstand von drei Monaten durchgeführt. Mittels der erfindungsgemäßen Erdleiter-Überwachungseinrichtung ist eine quasi-permanente Erdschlussprüfung möglich.

Ein weiterer Vorteil der Erfindung besteht darin, dass sich mittels der Erfindung auch langsam anbahnende Erdschlüsse erkennen lassen. Mittels der Erfindung ist daher eine vorausschauende Wartung elektrischer Anlagen möglich. Auf diese Weise können problematische Stillstandszeiten solcher Anlagen vermieden oder zumindest reduziert werden, da vorausschauende Wartungen durchgeführt werden können.

Dies kann in einer vorteilhaften Ausgestaltung der Erfindung dadurch begünstigt werden, dass nicht nur niederohmige Kurzschlüsse des Erdleiters zum ersten elektrischen Potenzial oder dem zweiten elektrischen Potenzial erkannt werden, sondern auch bereits etwas höherohmige Verbindungen, z.B. im Bereich von mehreren Kiloohm. Zudem ist es aufgrund der quasi-permanenten Überwachung mittels der Erfindung möglich, intermittierende Erdschlüsse zu erkennen.

Das erste elektrische Potenzial kann bei einem Anwendungsfall in der Automatisierungstechnik beispielsweise ein 0 Volt-Potenzial sein. Das zweite elektrische Potenzial kann die Betriebsspannung des Netzteils der Automatisierungsanlage sein, z.B. eine Kleinspannung, insbesondere eine Gleichspannung. Das zweite elektrische Potenzial kann z.B. ein 12 Volt-, 24 Volt- oder 48 Volt-Potenzial sein.

Die elektrische Schalteinrichtung kann auf unterschiedlichste Arten realisiert werden. In einer ersten Variante ist es möglich, das bisherige, manuell zu betätigende Trennmesser der Erdleiter-Trennklemme weiter zu nutzen und dieses automatisch durch einen Elektroantrieb anzutreiben, z.B. mittels eines Elektromotors oder eines Elektromagneten. In einer zweiten Variante ist es möglich, die elektrische Schalteinrichtung durch einen elektromechanischen Schalter zu realisieren, z.B. ein Relais oder ein Schütz. In einer dritten Variante kann die elektrische Schalteinrichtung als Halbleiterschalter ausgebildet sein, z.B. als Transistor, Thyristor oder Schaltungsanordnung aus Transistoren und/oder Thyristoren. Dies hat den Vorteil, dass das Umschalten zwischen dem Verbindungszustand und dem Unterbrechungszustand quasi verschleißfrei und geräuschfrei möglich ist. Zudem kann die elektrische Schalteinrichtung kostengünstig und mit sehr geringem Platzbedarf realisiert werden.

Die elektrische Schalteinrichtung weist zumindest zwei Schaltzustände auf, nämlich einen Verbindungszustand und einen Unterbrechungszustand. Im Verbindungszustand ist der erste Potenzialanschluss über die elektrische Schalteinrichtung mit dem Erdleiter-Anschluss verbunden, im Unterbrechungszustand ist die elektrische Verbindung zwischen dem ersten Potenzialanschluss und dem Erdleiter-Anschluss mittels der elektrischen Schalteinrichtung unterbrochen. Es ist vorteilhaft, wenn die elektrische Schalteinrichtung im Verbindungszustand den ersten Potenzialanschluss relativ niederohmig mit dem Erdleiter-Anschluss verbindet. Die elektrische Schalteinrichtung kann weitere Schaltzustände aufweisen, z.B. einen Zwischenzustand, in dem die elektrische Verbindung zwischen dem ersten Potenzialanschluss und dem Erdleiter-Anschluss hochohmiger hergestellt ist als im Verbindungszustand.

Gemäß einer vorteilhaften Ausgestaltung der Erfindung ist vorgesehen, dass die Steuereinrichtung dazu eingerichtet ist, zumindest im Unterbrechungszustand elektrische Signale am Erdleiter-Anschluss auszuwerten. Auf diese Weise wird es möglich, dass mit der erfindungsgemäßen Erdleiter-Überwachungseinrichtung vergleichbare Erdschlussprüfungen wie bei der bisherigen manuellen Vorgehensweise durchgeführt werden können. Die Steuereinrichtung kann zusätzlich dazu eingerichtet sein, auch im Verbindungszustand elektrische Signale am Erdleiter-Anschluss auszuwerten.

Gemäß einer vorteilhaften Ausgestaltung der Erfindung ist vorgesehen, dass die Steuereinrichtung dazu eingerichtet ist, mittels der von der Steuereinrichtung erzeugten Ansteuersignale automatisch in vorbestimmten regelmäßigen und/oder unregelmäßigen Zeitabständen die elektrische Schalteinrichtung zwischen den Schaltzuständen Verbindungszustand und Unterbrechungszustand umzuschalten. Auf diese Weise kann die bisherige manuelle Erdschlussprüfung vollständig automatisch durchgeführt werden. Durch die automatische Durchführung kann insbesondere die Prüfhäufigkeit deutlich erhöht werden, z.B. auf mehrere Erdschlussprüfungen pro Minute. Die Steuereinrichtung kann als Ansteuersignale insbesondere ein Einschaltsignal und ein Ausschaltsignal erzeugen und an die elektrische Schalteinrichtung abgeben. Diese Einschaltsignale und Ausschaltsignale ergeben in ihrer Folge dann ein pulsbreitenmoduliertes Signal (PWM-Signal), mit dem die elektrische Schalteinrichtung angesteuert wird.

Gemäß einer vorteilhaften Ausgestaltung der Erfindung ist vorgesehen, dass der Verbindungszustand im zeitlichen Mittel öfter angesteuert ist als der Unterbrechungszustand. Dies hat den Vorteil, dass für die Auswertung der elektrischen Signale am Erdleiter-Anschluss nur kurze Testpulse erforderlich sind, in denen der Unterbrechungszustand vorliegt. Ansonsten liegt immer der an sich erwünschte Verbindungszustand vor. Dadurch, dass der Verbindungszustand im zeitlichen Mittel häufiger vorliegt als der Unterbrechungszustand, kann zudem im Fehlerfall, d.h. bei einem aufgetretenen Erdschluss, ein ordnungsgemäßes Auslösen der Sicherungen gewährleistet werden. Auf diese Weise können die einschlägigen Vorschriften erfüllt werden.

So kann beispielsweise das pulsbreitenmodulierte Signal mit einem Tastverhältnis von 95 % Einschaltdauer zu 5 % Ausschaltdauer geschaltet werden. Dementsprechend liegt der Verbindungszustand zu 95 % der Zeit vor. Allgemein gesagt kann das Tastverhältnis beispielsweise im Bereich von 90 % bis 99 % Einschaltdauer liegen. Die Ausschaltdauer, d.h. die Dauer des Unterbrechungszustands, kann weniger als 500 ms betragen, oder weniger als 100 ms oder weniger als 10 ms. Die Periodendauer des pulsbreitenmodulierten Signals kann z.B. bei 10 Sekunden liegen. Generell ist es auch möglich, wesentlich kürzere Periodendauern zu realisieren. Zur Erfüllung der einschlägigen Vorschriften ist es vorteilhaft, wenn die Einschaltdauer des pulsbreitenmodulierten Signals mindestens fünf Sekunden beträgt.

Gemäß der Erfindung ist vorgesehen, dass die Auswertung der elektrischen Signale am Erdleiter-Anschluss ohne Messung des Stroms im Erdleiter erfolgt. Dies hat den Vorteil, dass für die Erdschlussprüfung keine aufwendigen Bauelemente wie z.B. ein Shunt erforderlich sind. Zudem können Risiken, die sich aus einer Unterbrechung des Erdleiters ergeben können, minimiert werden.

Gemäß einer vorteilhaften Ausgestaltung der Erfindung ist vorgesehen, dass die Erdleiter-Überwachungseinrichtung dazu eingerichtet ist, anhand der ausgewerteten elektrischen Signale am Erdleiter-Anschluss zu erkennen, ob der Erdleiter mit dem ersten elektrischen Potenzial verbunden ist und/oder ob der Erdleiter mit dem zweiten elektrischen Potenzial verbunden ist. Auf diese Weise können mit der erfindungsgemäßen Erdleiter-Überwachungseinrichtung mindestens die gleichen Fehlerfälle am Erdleiter erkannt werden wie bei den bisherigen manuellen Überprüfungen.

Gemäß einer vorteilhaften Ausgestaltung der Erfindung ist vorgesehen, dass die Erdleiter-Überwachungseinrichtung eine Lichtsignaleinrichtung aufweist, über die automatisch ein Lichtsignal abgebbar ist, wenn von der Erdleiter-Überwachungseinrichtung erkannt wird, dass der Erdleiter mit dem ersten Potenzial verbunden ist und/oder der Erdleiter mit dem zweiten Potenzial verbunden ist. Die Lichtsignaleinrichtung kann eine oder mehrere Lichtquellen aufweisen. Auf diese Weise kann einem Anwender das Vorliegen eines Erdschlusses optisch signalisiert werden. Es kann beispielsweise ein Warnsignal über eine oder mehrere Lichtquellen ausgegeben werden, z.B. über Leuchtdioden (LEDs) oder Glimmlampen.

Gemäß einer vorteilhaften Ausgestaltung der Erfindung ist vorgesehen, dass die Erdleiter-Überwachungseinrichtung eine Ausgangsschnittstelle aufweist, über die automatisch ein Warnsignal abgebbar ist, wenn von der Erdleiter-Überwachungseinrichtung erkannt wird, dass der Erdleiter mit dem ersten Potenzial verbunden ist und/oder der Erdleiter mit dem zweiten Potenzial verbunden ist. Auf diese Weise kann mittels der Erdleiter-Überwachungseinrichtung eine daran angeschlossene Einrichtung angesteuert werden, z.B. ein Leitrechner (SPS) der Anlage.

Gemäß einer vorteilhaften Ausgestaltung der Erfindung ist vorgesehen, dass die Ausgangsschnittstelle einen potenzialfreien Ausgangsanschluss aufweist. Dies hat den Vorteil, dass auf einfache Weise weitere Komponenten mit dem Ausgangsanschluss verbunden werden können. Der Ausgangsanschluss kann beispielsweise als ISO-OK-Kontakt ausgebildet sein. Alternativ oder zusätzlich kann der Ausgangsanschluss auch ein Datenbusanschluss sein, sodass über einen Datenbus das Warnsignal übertragen werden kann.

Gemäß einer vorteilhaften Ausgestaltung der Erfindung ist vorgesehen, dass die Erdleiter-Überwachungseinrichtung eine Auswerteschaltung aufweist, über die mittels der Steuereinrichtung zumindest im Unterbrechungszustand die elektrischen Signale am Erdleiter-Anschluss auswertbar sind. Dies hat den Vorteil, dass die Überwachung schaltungstechnisch gelöst wird, sodass mit geringem Aufwand eine schnelle Überwachung möglich ist und keine Software-bedingten Verzögerungen oder sonstigen Nachteile auftreten können.

Die übrigen Elemente der Erdleiter-Überwachungseinrichtung, insbesondere die Steuerungseinheit, kann dabei vollständig ohne Rechner oder sonstige ein Computerprogramm ausführende Einheit ausgebildet sein, z.B. in Form einer Logikschaltung. Für die Erzeugung der Ansteuersignale kann die Steuereinrichtung beispielsweise einen Hardware-Timer aufweisen.

Gemäß einer vorteilhaften Ausgestaltung der Erfindung ist vorgesehen, dass die Auswerteschaltung wenigstens eine zwischen dem Erdleiter-Anschluss und dem ersten Potenzialanschluss geschaltete erste Spannungserfassungseinrichtung und/oder wenigstens eine zwischen dem Erdleiter-Anschluss und dem zweiten Potenzialanschluss geschaltete zweite Spannungserfassungseinrichtung aufweist. Dies erlaubt eine einfache Erfassung und Auswertung der elektrischen Signale am Erdleiter-Anschluss. Die erste Spannungserfassungseinrichtung und/oder die zweite Spannungserfassungseinrichtung kann beispielsweise eine Triggerschwelle aufweisen, sodass die Spannungserfassungseinrichtung als Ausgangssignal ein Triggersignal abgibt, wenn die durch die Spannungserfassungseinrichtung überwachte Spannung die Triggerschwelle erreicht, überschreitet oder unterschreitet. Dies ermöglicht eine einfache nachgelagerte Signalverarbeitung der Triggersignale, die als Binärsignale ausgebildet sein können. Die weitere Auswertung der Triggersignale kann dann beispielsweise durch eine Auswertelogik erfolgen, z.B. durch Flip-Flop-Speicher.

Die erste Spannungserfassungseinrichtung kann dazu eingerichtet sein, den Isolationswiderstand zwischen dem Erdleiter-Anschluss und dem ersten Potenzialanschluss zu erfassen. Die zweite Spannungserfassungseinrichtung kann dazu eingerichtet sein, den Isolationswiderstand zwischen dem Erdleiter-Anschluss und dem zweiten Potenzialanschluss zu erfassen. Beispielsweise kann das erwähnte Triggersignal erzeugt werden, wenn der Isolationswiderstand einen vorbestimmten Widerstandswert unterschreitet, beispielsweise einen Wert von 1 kΩ.

Gemäß einer vorteilhaften Ausgestaltung der Erfindung ist vorgesehen, dass die erste und/oder die zweite Spannungserfassungseinrichtung als Optokoppler ausgebildet ist oder einen Optokoppler aufweist. Dies erlaubt eine einfache und kostengünstige sowie eine langlebige Realisierung der ersten und/oder zweiten Spannungserfassungseinrichtung. Die Optokoppler können insbesondere derart geschaltet sein, dass die jeweilige Leuchtdiode des Optokopplers ausgeschaltet ist, wenn kein Erdschluss vorliegt. Lediglich im Fehlerfall, wenn ein Erdschluss vorliegt, schaltet sich die Leuchtdiode ein. Auf diese Weise können die Leuchtdioden der Optokoppler geschont werden.

Gemäß vorteilhaften Ausgestaltung der Erfindung ist vorgesehen, dass die Erdleiter-Überwachungseinrichtung eine Stromversorgungseinrichtung aufweist, die dazu eingerichtet ist, wenigstens die Steuerungseinheit und die elektrische Schalteinrichtung mit der zum Betrieb erforderlichen elektrischen Energie zu versorgen, wobei die Stromversorgungseinrichtung die elektrische Energie aus dem ersten und dem zweiten Potenzialanschluss entnimmt und mittels einer Pufferschaltung gepuffert abgibt. Die Pufferschaltung kann insbesondere derart ausgelegt sein, dass damit Zeiträume, in denen der Verbindungszustand vorliegt, überbrückt werden können, d.h. das auch im Verbindungszustand die elektrische Schalteinrichtung und die Steuerungseinheit über die Stromversorgungseinrichtung weiterhin mit elektrischer Energie versorgt ist. Die Pufferschaltung kann insbesondere einen Pufferkondensator aufweisen. Auf diese Weise kann vermieden werden, dass die Funktion der Erdleiter-Überwachungseinrichtung gestört wird, wenn der Erdleiter einen vergleichsweise niederohmigen Kurzschluss zum zweiten elektrischen Potenzialanschluss aufweist.

Gemäß einer vorteilhaften Ausgestaltung der Erfindung ist die Erdleiter-Überwachungseinrichtung als Reihenklemme ausgebildet oder in oder an einer Reihenklemme angeordnet. Die Erdleiter-Überwachungseinrichtung kann beispielsweise baulich in das Gehäuse einer Reihenklemme integriert sein. Eine Reihenklemme ist ein in der elektrischen Installationstechnik verwendeter Gegenstand, der zur Befestigung an einer Tragschiene eingerichtet ist und mit anderen Reihenklemmen nebeneinander an der Tragschiene aufgereiht werden kann. Eine Reihenklemme weist mehrere Leiteranschlüsse auf, z.B. in Form von Federkraft-Klemmanschlüssen, so dass an die Reihenklemme mehrere elektrische Leiter angeschlossen werden können.

Die eingangs genannte Aufgabe wird außerdem gelöst durch ein Verfahren zur Überwachung eines Erdleiters im Sinne eines Schutzleiters eines mittels des Erdleiters geerdeten elektrischen Geräts, das mittels eines ersten elektrischen Potenzials, das sich vom Erdleiter-Potenzial des Erdleiters unterscheidet, und eines zweiten elektrischen Potenzials, das sich vom ersten Potenzial und vom Erdleiter-Potenzial unterscheidet, elektrische Energie bereitstellt und/oder mit elektrischer Energie versorgt wird, mit folgenden Merkmalen:
a) mittels wenigstens einer elektrischen Schalteinrichtung wird automatisch in vorbestimmten regelmäßigen und/oder unregelmäßigen Zeitabständen zwischen den Schaltzuständen Verbindungszustand und Unterbrechungszustand umgeschaltet, wobei im Verbindungszustand eine elektrische Verbindung zwischen dem ersten elektrischen Potenzial und dem Erdleiter mittels der elektrischen Schalteinrichtung hergestellt ist und im Unterbrechungszustand die elektrische Verbindung zwischen dem ersten elektrischen Potenzial und dem Erdleiter mittels der elektrischen Schalteinrichtung unterbrochen ist,
b) zumindest im Unterbrechungszustand werden elektrische Signale am Erdleiter erfasst und ausgewertet,
c) anhand der ausgewerteten elektrischen Signale am Erdleiter wird erkannt, ob der Erdleiter mit dem ersten elektrischen Potenzial verbunden ist und/oder ob der Erdleiter mit dem zweiten elektrischen Potenzial verbunden ist,
dadurch gekennzeichnet, dass die Auswertung der elektrischen Signale am Erdleiter-Anschluss (13) ohne Messung des Stroms im Erdleiter erfolgt.

Auch hierdurch können die zuvor erläuterten Vorteile realisiert werden.

Gemäß einer vorteilhaften Ausgestaltung des Verfahrens ist vorgesehen, dass ein Warnsignal abgegeben wird, wenn erkannt wird, dass der Erdleiter mit dem ersten Potenzial verbunden ist und/oder wenn der Erdleiter mit dem zweiten Potenzial verbunden ist. Auf diese Weise kann einem Anwender das Vorliegen eines Erdschlusses signalisiert werden. Es kann beispielsweise ein Warnsignal über eine oder mehrere Lichtquellen ausgegeben werden, z.B. über Leuchtdioden (LEDs) oder Glimmlampen, oder über die Ausgangsschnittstelle.

Gemäß einer vorteilhaften Ausgestaltung ist vorgesehen, dass das Verfahren mittels einer Erdleiter-Überwachungseinrichtung der zuvor erläuterten Art ausgeführt wird.

Die eingangs genannte Aufgabe wird außerdem gelöst durch ein Computerprogramm mit Programmcodemitteln, eingerichtet zur Ausführung eines Verfahrens der zuvor erläuterten Art, wenn das Computerprogramm auf einem Rechner ausgeführt wird. Auch hierdurch können die zuvor erläuterten Vorteile realisiert werden.

Im Sinne der vorliegenden Erfindung ist unter dem unbestimmten Begriff "ein" kein Zahlwort zu verstehen. Wenn also z.B. von einem Bauteil die Rede ist, so ist dies im Sinne von "mindestens einem Bauteil" zu interpretieren. Soweit Winkelangaben in Grad gemacht werden, beziehen sich diese auf ein Kreismaß von 360 Grad (360°). Soweit ein Rechner erwähnt ist, kann dieser dazu eingerichtet sein, ein Computerprogramm, z.B. im Sinne von Software, auszuführen. Der Rechner kann als handelsüblicher Computer ausgebildet sein, z.B. als PC, Laptop, Notebook, Tablet oder Smartphone, oder als Mikroprozessor, Mikrocontroller oder FPGA, oder als Kombination aus solchen Elementen.

Die Erfindung wird nachfolgend anhand von Ausführungsbeispielen unter Verwendung von Zeichnungen näher erläutert. Es zeigen:
- Figur 1 -: eine Reihenklemme mit einer Erdleiter-Überwachungseinrichtung und
- Figur 2 -: eine Erdleiter-Überwachungseinrichtung in schematischer Darstellung und
- Figur 3 -: eine Auswerteschaltung einer Erdleiter-Überwachungseinrichtung.

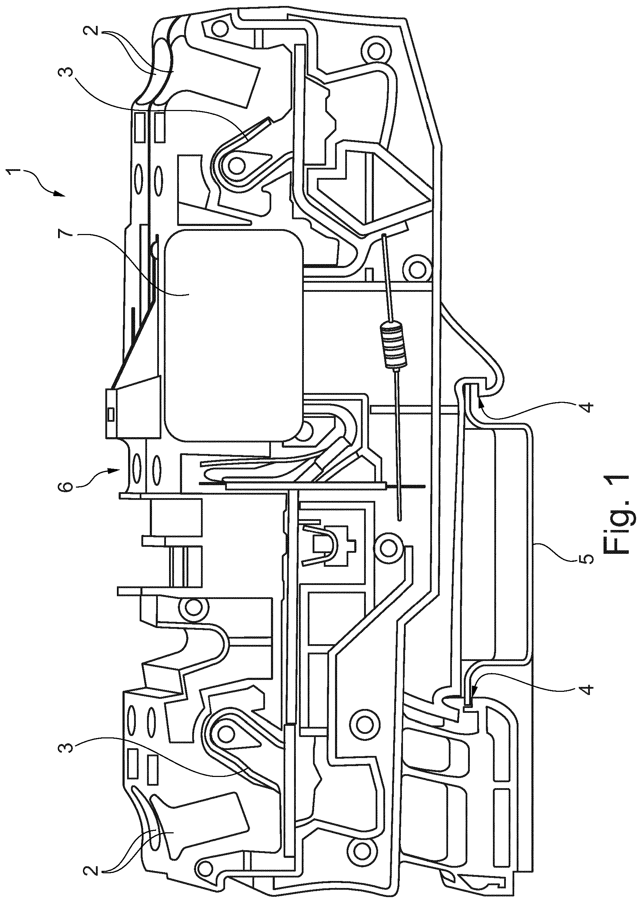

Die Figur 1 zeigt eine Reihenklemme 1, die zur Befestigung an einer Tragschiene 5 eingerichtet ist. Die Reihenklemme 1 weist hierfür an einer zur Tragschiene 5 ausgerichteten Gehäuseseite Tragschienenbefestigungselemente 4 auf. Die Reihenklemme 1 kann beispielsweise mittels der Tragschienenbefestigungselemente 4 an der Tragschiene 5 aufgerastet werden. Die Tragschiene 5 kann das Erdleiter-Potenzial PE aufweisen.

Die Reihenklemme 1 weist mehrere Leitereinführungsöffnungen 2 auf, die zu jeweiligen Leiteranschlüssen 3 führen. Die Leiteranschlüsse 3 können vorteilhaft als Federkraft-Klemmanschlüsse ausgebildet sein. Über die Leiteranschlüsse 3 können in die Leitereinführungsöffnungen 2 eingesteckte elektrische Leiter an der Reihenklemme 1 elektrisch angeschlossen werden.

Die Reihenklemme 1 weist außerdem eine Erdleiter-Überwachungseinrichtung 7 auf. An einer von den Tragschienenbefestigungselementen 4 abgewandten Gehäuseseite ist eine Lichtsignaleinheit 6 vorhanden, die Teil der Erdleiter-Überwachungseinrichtung 7 sind. Über die Lichtsignaleinheit 6 kann beispielsweise ein von der Erdleiter-Überwachungseinrichtung 7 erkannter Erdschlussfehler optisch signalisiert werden.

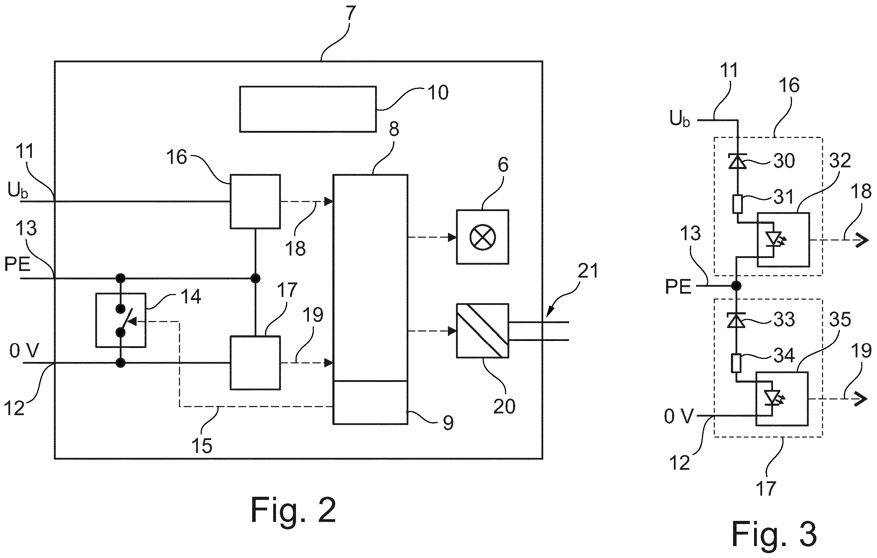

Die Figur 2 zeigt den Aufbau der Erdleiter-Überwachungseinrichtung 7. Die Erdleiter-Überwachungseinrichtung 7 weist einen Erdleiter-Anschluss 13 auf, an den ein Erdleiter-Potenzial PE angeschlossen werden kann. Die Erdleiter-Überwachungseinrichtung 7 weist einen ersten Potenzialanschluss 12 auf, an den ein erstes Potenzial 0 V angeschlossen werden kann. Die Erdleiter-Überwachungseinrichtung 7 weist einen zweiten Potenzialanschluss 11 auf, an den ein zweites elektrisches Potenzial U_{b} angeschlossen werden kann.

Die Erdleiter-Überwachungseinrichtung 7 weist ferner eine elektrische Schalteinrichtung 14, eine Auswerteschaltung mit einer ersten Spannungserfassungseinrichtung 17 und einer zweiten Spannungserfassungseinrichtung 16, eine Steuerungseinheit 8 mit einem Timer 9, die Lichtsignaleinheit 6, eine Ausgangsschnittstelle 20 und eine Stromversorgungseinrichtung 10 auf. Die Stromversorgungseinrichtung 10 dient zur Versorgung der elektrisch zu versorgenden Elemente der Erdleiter-Überwachungseinrichtung 7 mit elektrischer Energie. Die für die Versorgung erforderliche elektrische Energie wird aus der Spannungsdifferenz zwischen dem ersten Potenzialanschluss 12 und dem zweiten Potenzialanschluss 11 gewonnen.

Die Steuerungseinheit 8 ist, in diesem Fall über ihren Timer 9, über eine Signalleitung 15 mit einem Steuereingang der elektrischen Schalteinrichtung 14 verbunden. Über die Signalleitung 15 kann der Timer 9 elektrische Ansteuersignale an die elektrische Schalteinrichtung 14 abgeben und diese damit derart ansteuern, dass eine elektrische Verbindung zwischen dem ersten Potenzialanschluss 12 und dem Erdleiter-Anschluss 13 hergestellt wird oder unterbrochen wird.

Die erste Spannungserfassungseinrichtung 17 ist mit dem ersten Potenzialanschluss 12 und dem Erdleiter-Anschluss 13 verbunden. Die erste Spannungserfassungseinrichtung 17 kann damit die Spannung zwischen diesen Anschlüssen auswerten. Bei Erkennung einer bestimmten Spannung zwischen diesen Anschlüssen, die auf die Unterschreitung eines bestimmten Isolationswiderstands hindeutet, gibt die erste Spannungserfassungseinrichtung 17 ein Signal über eine Signalleitung 19 an die Steuerungseinheit 8. Dieses Signal deutet dann auf einen Erdschluss des zweiten Potenzialanschlusses 11 hin.

Die zweite Spannungserfassungseinrichtung 16 ist mit dem zweiten Potenzialanschluss 11 und dem Erdleiter-Anschluss 13 verbunden. Die zweite Spannungserfassungseinrichtung 16 kann damit die Spannung zwischen diesen Anschlüssen auswerten. Bei Erkennung einer bestimmten Spannung zwischen diesen Anschlüssen, die auf die Unterschreitung eines bestimmten Isolationswiderstands hindeutet, gibt die zweite Spannungserfassungseinrichtung 16 ein Signal über eine Signalleitung 18 an die Steuerungseinheit 8. Dieses Signal deutet dann auf einen Erdschluss des ersten Potenzialanschlusses 12 hin.

In der Steuerungseinheit 8 werden die über die Signalleitungen 18, 19 empfangenen Signale ausgewertet und im Falle eines Erdschlusses die Lichtsignaleinrichtung 6 angesteuert. Alternativ oder zusätzlich kann ein Warnsignal über die Ausgangsschnittstelle 20 an einem Ausgangsanschluss 21 abgegeben werden. Hiermit kann z.B. eine SPS angesteuert werden.

Die Figur 3 zeigt eine vorteilhafte Ausgestaltung der ersten Spannungserfassungseinrichtung 17 und der zweiten Spannungserfassungseinrichtung 16. Die erste Spannungserfassungseinrichtung 17 weist eine Reihenschaltung aus einer Zener-Diode 33, einem Widerstand 34 und der Leuchtdiode eines Optokopplers 35 auf. Der Optokoppler 35 weist einen Ausgangsanschluss auf, der mit der Signalleitung 19 verbunden ist, so dass bei eingeschalteter Leuchtdiode des Optokopplers 35 das entsprechende Signal an die Steuerungseinheit 8 abgegeben werden kann.

Die zweite Spannungserfassungseinrichtung 16 weist eine Reihenschaltung aus einer Zener-Diode 30, einem Widerstand 31 und der Leuchtdiode eines Optokopplers 32 auf. Der Optokoppler 32 weist einen Ausgangsanschluss auf, der mit der Signalleitung 18 verbunden ist, so dass bei eingeschalteter Leuchtdiode des Optokopplers 32 das entsprechende Signal an die Steuerungseinheit 8 abgegeben werden kann.

## Patentansprüche

1. Erdleiter-Überwachungseinrichtung (7) für die Überwachung eines Erdleiters im Sinne eines Schutzleiters, über den ein elektrisches Gerät geerdet ist, aufweisend:
a) wenigstens einen Erdleiter-Anschluss (13), der zum Anschluss eines Erdleiter-Potenzials (PE) des Erdleiters eingerichtet ist,
b) wenigstens einen ersten Potenzialanschluss (12), der zum Anschluss eines ersten elektrischen Potenzials (0 V) eingerichtet ist, das sich vom Erdleiter-Potenzial (PE) unterscheidet,
c) wenigstens einen zweiten Potenzialanschluss (11), der zum Anschluss eines zweiten elektrischen Potenzials (U_{b}) eingerichtet ist, das sich vom ersten Potenzial (0 V) und vom Erdleiter-Potenzial (PE) unterscheidet,
d) wenigstens eine elektrische Schalteinrichtung (14), die dazu eingerichtet ist, wahlweise in Abhängigkeit von einem elektrischen Ansteuersignal eine elektrische Verbindung zwischen dem ersten Potenzialanschluss (12) und dem Erdleiter-Anschluss (13) herzustellen (Verbindungszustand) oder zu unterbrechen (Unterbrechungszustand),
e) wenigstens eine Steuerungseinheit (8), die dazu eingerichtet ist, automatisch Ansteuersignale an die elektrische Schalteinrichtung (14) abzugeben,
**dadurch gekennzeichnet, dass** die Auswertung der elektrischen Signale am Erdleiter-Anschluss (13) ohne Messung des Stroms im Erdleiter erfolgt.

2. Erdleiter-Überwachungseinrichtung nach Anspruch 1, **dadurch gekennzeichnet, dass** die Steuereinrichtung (8) dazu eingerichtet ist, zumindest im Unterbrechungszustand elektrische Signale am Erdleiter-Anschluss (13) auszuwerten.

3. Erdleiter-Überwachungseinrichtung nach einem der vorhergehenden Ansprüche, **dadurch gekennzeichnet, dass** die Steuereinrichtung (8) dazu eingerichtet ist, mittels der von der Steuereinrichtung (8) erzeugten Ansteuersignale automatisch in vorbestimmten regelmäßigen und/oder unregelmäßigen Zeitabständen die elektrische Schalteinrichtung (14) zwischen den Schaltzuständen Verbindungszustand und Unterbrechungszustand umzuschalten.

4. Erdleiter-Überwachungseinrichtung nach einem der vorhergehenden Ansprüche, **dadurch gekennzeichnet, dass** der Verbindungszustand im zeitlichen Mittel öfter angesteuert ist als der Unterbrechungszustand.

5. Erdleiter-Überwachungseinrichtung nach einem der vorhergehenden Ansprüche, **dadurch gekennzeichnet, dass** die Erdleiter-Überwachungseinrichtung (7) dazu eingerichtet ist, anhand der ausgewerteten elektrischen Signale am Erdleiter-Anschluss (13) zu erkennen, ob der Erdleiter mit dem ersten elektrischen Potenzial (0 V) verbunden ist und/oder ob der Erdleiter mit dem zweiten elektrischen Potenzial (U_{b}) verbunden ist.

6. Erdleiter-Überwachungseinrichtung nach einem der vorhergehenden Ansprüche, **dadurch gekennzeichnet, dass** die elektrische Schalteinrichtung (14) als Halbleiterschalter ausgebildet ist.

7. Erdleiter-Überwachungseinrichtung nach einem der vorhergehenden Ansprüche, **dadurch gekennzeichnet, dass** die Erdleiter-Überwachungseinrichtung (7) eine Lichtsignaleinrichtung (6) aufweist, über die automatisch ein Lichtsignal abgebbar ist, wenn von der Erdleiter-Überwachungseinrichtung (7) erkannt wird, dass der Erdleiter mit dem ersten Potenzial (0 V) verbunden ist und/oder der Erdleiter mit dem zweiten Potenzial (U_{b}) verbunden ist.

8. Erdleiter-Überwachungseinrichtung nach einem der vorhergehenden Ansprüche, **dadurch gekennzeichnet, dass** die Erdleiter-Überwachungseinrichtung (7) eine Ausgangsschnittstelle (20) aufweist, über die automatisch ein Warnsignal abgebbar ist, wenn von der Erdleiter-Überwachungseinrichtung (7) erkannt wird, dass der Erdleiter mit dem ersten Potenzial (0 V) verbunden ist und/oder der Erdleiter mit dem zweiten Potenzial (U_{b}) verbunden ist.

9. Erdleiter-Überwachungseinrichtung nach Anspruch 8, **dadurch gekennzeichnet, dass** die Ausgangsschnittstelle (20) einen potenzialfreien Ausgangsanschluss aufweist.

10. Erdleiter-Überwachungseinrichtung nach Anspruch 2, **dadurch gekennzeichnet, dass** die Erdleiter-Überwachungseinrichtung (7) eine Auswerteschaltung aufweist, über die mittels der Steuereinrichtung (8) zumindest im Unterbrechungszustand die elektrischen Signale am Erdleiter-Anschluss (13) auswertbar sind.

11. Erdleiter-Überwachungseinrichtung nach Anspruch 10, **dadurch gekennzeichnet, dass** die Auswerteschaltung wenigstens eine zwischen dem Erdleiter-Anschluss (13) und dem ersten Potenzialanschluss (12) geschaltete erste Spannungserfassungseinrichtung (17) und/oder wenigstens eine zwischen dem Erdleiter-Anschluss (13) und dem zweiten Potenzialanschluss (11) geschaltete zweite Spannungserfassungseinrichtung (16) aufweist.

12. Erdleiter-Überwachungseinrichtung nach Anspruch 11, **dadurch gekennzeichnet, dass** die erste und/oder die zweite Spannungserfassungseinrichtung (16, 17) als Optokoppler (32, 35) ausgebildet ist oder einen Optokoppler (32, 35) aufweist.

13. Erdleiter-Überwachungseinrichtung nach einem der vorhergehenden Ansprüche, **dadurch gekennzeichnet, dass** die Erdleiter-Überwachungseinrichtung (7) eine Stromversorgungseinrichtung (10) aufweist, die dazu eingerichtet ist, wenigstens die Steuerungseinheit (8) und die elektrische Schalteinrichtung (14) mit der zum Betrieb erforderlichen elektrischen Energie zu versorgen, wobei die Stromversorgungseinrichtung (10) die elektrische Energie aus dem ersten und dem zweiten Potenzialanschluss (11, 12) entnimmt und mittels einer Pufferschaltung gepuffert abgibt.

14. Erdleiter-Überwachungseinrichtung nach einem der vorhergehenden Ansprüche, **dadurch gekennzeichnet, dass** die Erdleiter-Überwachungseinrichtung (7) als Reihenklemme (1) ausgebildet ist oder in oder an einer Reihenklemme (1) angeordnet ist.

15. Computerprogramm mit Programmcodemitteln, eingerichtet zur Durchführung des nachfolgenden Verfahrens zur Überwachung eines Erdleiters im Sinne eines Schutzleiters eines mittels des Erdleiters geerdeten elektrischen Geräts, das mittels eines ersten elektrischen Potenzials (0 V), das sich vom Erdleiter-Potenzial (PE) des Erdleiters unterscheidet, und eines zweiten elektrischen Potenzials (U_{b}), das sich vom ersten Potenzial (0 V) und vom Erdleiter-Potenzial (PE) unterscheidet, elektrische Energie bereitstellt und/oder mit elektrischer Energie versorgt wird, wenn das Computerprogramm auf einem Rechner ausgeführt wird:
a) mittels wenigstens einer elektrischen Schalteinrichtung (14) wird automatisch in vorbestimmten regelmäßigen und/oder unregelmäßigen Zeitabständen zwischen den Schaltzuständen Verbindungszustand und Unterbrechungszustand umgeschaltet, wobei im Verbindungszustand eine elektrische Verbindung zwischen dem ersten elektrischen Potenzial (0 V) und dem Erdleiter mittels der elektrischen Schalteinrichtung (14) hergestellt ist und im Unterbrechungszustand die elektrische Verbindung zwischen dem ersten elektrischen Potenzial (0 V) und dem Erdleiter mittels der elektrischen Schalteinrichtung (14) unterbrochen ist,
b) zumindest im Unterbrechungszustand werden elektrische Signale am Erdleiter erfasst und ausgewertet,
c) anhand der ausgewerteten elektrischen Signale am Erdleiter wird erkannt, ob der Erdleiter mit dem ersten elektrischen Potenzial (0 V) verbunden ist und/oder ob der Erdleiter mit dem zweiten elektrischen Potenzial (U_{b}) verbunden ist,
**dadurch gekennzeichnet, dass** die Auswertung der elektrischen Signale am Erdleiter-Anschluss (13) ohne Messung des Stroms im Erdleiter erfolgt.

## Claims

1. Earth conductor monitoring device (7) for monitoring an earth conductor in the sense of a protective conductor via which an electrical appliance is earthed:
a) at least one earth conductor connection (13), which is set up for connecting an earth conductor potential (PE) of the earth conductor,
b) at least one first potential connection (12), which is set up for connecting a first electrical potential (0 V) that is different from the earth conductor potential (PE),
c) at least one second potential connection (11), which is set up for connecting a second electrical potential (U_{b} ) that differs from the first potential (0 V) and the earth conductor potential (PE),
d) at least one electrical switching device (14) which is set up to selectively establish (connection state) or interrupt (interruption state) an electrical connection between the first potential connection (12) and the earth conductor connection (13) as a function of an electrical control signal,
e) at least one control device (8), which is set up to automatically emit control signals to the electrical switching device (14),
**characterized in that** the electrical signals at the earth conductor connection (13) are evaluated without measuring the current in the earth conductor.

2. Earth conductor monitoring device according to claim 1, **characterized in that** the control device (8) is set up to evaluate electrical signals at the earth conductor connection (13) at least in the interrupted state.

3. Earth conductor monitoring device according to one of the preceding claims, **characterized in that** the control device (8) is set up to automatically switch the electrical switching device (14) between the switching states connection state and interruption state at predetermined regular and/or irregular intervals by means of the actuation signals generated by the control device (8).

4. Earth conductor monitoring device according to one of the preceding claims, **characterized in that** the connection state is activated more often on average over time than the disconnection state.

5. Earth conductor monitoring device according to one of the preceding claims, **characterized in that** the earth conductor monitoring device (7) is set up to detect whether the earth conductor is connected to the first electrical potential (0 V) and/or whether the earth conductor is connected to the second electrical potential (U_{b}) on the basis of the evaluated electrical signals at the earth conductor connection (13).

6. Earth conductor monitoring device according to one of the preceding claims, **characterized in that** the electrical switching device (14) is designed as a semiconductor switch.

7. Earth conductor monitoring device according to one of the preceding claims, **characterized in that** the earth conductor monitoring device (7) has a light signal device (6) via which a light signal can be emitted automatically if the earth conductor monitoring device (7) detects that the earth conductor is connected to the first potential (0 V) and/or the earth conductor is connected to the second potential (U_{b}).

8. Earth conductor monitoring device according to one of the preceding claims, **characterized in that** the earth conductor monitoring device (7) has an output interface (20) via which a warning signal can be automatically emitted if it is detected by the earth conductor monitoring device (7) that the earth conductor is connected to the first potential (0 V) and/or the earth conductor is connected to the second potential (U_{b}).

9. Earth conductor monitoring device according to claim 8, **characterized in that** the output interface (20) has a potential-free output connection.

10. Earth conductor monitoring device according to claim 2, **characterized in that** the earth conductor monitoring device (7) has an evaluation circuit via which the electrical signals at the earth conductor connection (13) can be evaluated by means of the control device (8) at least in the interrupted state.

11. Earth conductor monitoring device according to claim 10, **characterized in that** the evaluation circuit has at least one first voltage detection device (17) connected between the earth conductor connection (13) and the first potential connection (12) and/or at least one second voltage detection device (16) connected between the earth conductor connection (13) and the second potential connection (11).

12. Earth conductor monitoring device according to claim 11, **characterized in that** the first and/or the second voltage detection device (16, 17) is designed as an optocoupler (32, 35) or has an optocoupler (32, 35).

13. Earth conductor monitoring device according to one of the preceding claims, **characterized in that** the earth conductor monitoring device (7) has a power supply device (10) which is set up to supply at least the control unit (8) and the electrical switching device (14) with the electrical energy required for operation, the power supply device (10) taking the electrical energy from the first and the second potential connection (11, 12) and outputting it in a buffered manner by means of a buffer circuit.

14. Earth conductor monitoring device according to one of the preceding claims, **characterized in that** the earth conductor monitoring device (7) is designed as a terminal block (1) or is arranged in or on a terminal block (1).

15. Computer program comprising program code means adapted to perform the following method for monitoring a ground conductor in the sense of a protective conductor of an electrical device grounded by means of the ground conductor, which provides and/or is supplied with electrical energy by means of a first electrical potential (0 V) different from the earth conductor potential (PE) of the earth conductor and a second electrical potential (U_{b}) different from the first potential (0 V) and the earth conductor potential (PE), when the computer program is executed on a computer:
a) an electrical connection between the first electrical potential (0 V) and the earth conductor is established by means of the electrical switching device (14) in the connection state and the electrical connection between the first electrical potential (0 V) and the earth conductor is interrupted by means of the electrical switching device (14) in the interruption state,
b) electrical signals on the earth conductor are detected and evaluated at least in the interrupted state,
c) the evaluated electrical signals on the earth conductor are used to detect whether the earth conductor is connected to the first electrical potential (0 V) and/or whether the earth conductor is connected to the second electrical potential (U_{b} ),
**characterized in that** the electrical signals at the earth conductor connection (13) are evaluated without measuring the current in the earth conductor.

## Revendications

1. Dispositif (7) de surveillance d'un conducteur de terre, destiné à surveiller un conducteur faisant office de conducteur de protection, par l'intermédiaire duquel un appareil électrique est mis à la terre, comprenant :
a) au moins une connexion de conducteur de terre (13) conçue pour connecter un potentiel (PE) du conducteur de terre,
b) au moins une première connexion de potentiel (12) conçue pour connecter un premier potentiel électrique (0 V) qui est différent du potentiel (PE) du conducteur de terre,
c) au moins une deuxième connexion de potentiel (11) conçue pour connecter un deuxième potentiel électrique (U_{b}) qui est différent du premier potentiel (0 V) et du potentiel (PE) du conducteur de terre,
d) au moins un dispositif de commutation électrique (14) conçu pour, au choix, établir (état de liaison) ou interrompre (état d'interruption) une liaison électrique entre la première connexion de potentiel (12) et la connexion de conducteur de terre (13), en fonction d'un signal de commande électrique,
e) au moins une unité de commande (8) conçue pour délivrer automatiquement des signaux de commande au dispositif de commutation électrique (14),
**caractérisé en ce que** l'évaluation des signaux électriques au niveau de la connexion de conducteur de terre (13) est effectuée sans mesurer le courant dans le conducteur de terre.

2. Dispositif de surveillance de conducteur de terre selon la revendication 1, **caractérisé en ce que** l'unité de commande (8) est conçue pour évaluer, au moins dans l'état d'interruption, des signaux électriques au niveau de la connexion de conducteur de terre (13).

3. Dispositif de surveillance de conducteur de terre selon l'une des revendications précédentes,
**caractérisé en ce que** l'unité de commande (8) est conçue pour faire commuter automatiquement le dispositif de commutation électrique (14) entre les états de commutation que sont l'état de liaison et l'état d'interruption à l'aide des signaux de commande générés par l'unité de commande (8) à des intervalles de temps réguliers et/ou irréguliers prédéterminés.

4. Dispositif de surveillance de conducteur de terre selon l'une des revendications précédentes,
**caractérisé en ce que** l'état de liaison est commandé plus souvent que l'état d'interruption, en moyenne dans le temps.

5. Dispositif de surveillance de conducteur de terre selon l'une des revendications précédentes,
**caractérisé en ce que** le dispositif de surveillance de conducteur de terre (7) est conçu pour détecter, à l'aide des signaux électriques évalués au niveau de la connexion de conducteur de terre (13), si le conducteur de terre est relié au premier potentiel électrique (0 V) et/ou si le conducteur de terre est relié au deuxième potentiel électrique (U_{b}).

6. Dispositif de surveillance de conducteur de terre selon l'une des revendications précédentes,
**caractérisé en ce que** le dispositif de commutation électrique (14) est conçu comme un commutateur à semi-conducteurs.

7. Dispositif de surveillance de conducteur de terre selon l'une des revendications précédentes,
**caractérisé en ce que** le dispositif de surveillance de conducteur de terre (7) présente un dispositif de signalisation lumineuse (6) permettant d'émettre automatiquement un signal lumineux lorsque le dispositif de surveillance de conducteur de terre (7) a détecté que le conducteur de terre est relié au premier potentiel (0 V) et/ou que le conducteur de terre est relié au deuxième potentiel (U_{b}).

8. Dispositif de surveillance de conducteur de terre selon l'une des revendications précédentes,
**caractérisé en ce que** le dispositif de surveillance de conducteur de terre (7) présente une interface de sortie (20) permettant d'émettre automatiquement un signal d'avertissement lorsque le dispositif de surveillance de conducteur de terre (7) a détecté que le conducteur de terre est relié au premier potentiel (0 V) et/ou que le conducteur de terre est relié au deuxième potentiel (U_{b}).

9. Dispositif de surveillance de conducteur de terre selon la revendication 8, **caractérisé en ce que** l'interface de sortie (20) présente une connexion de sortie sans potentiel.

10. Dispositif de surveillance de conducteur de terre selon la revendication 2,
**caractérisé en ce que** le dispositif de surveillance de conducteur de terre (7) présente un circuit d'évaluation permettant d'évaluer les signaux électriques au niveau de la connexion de conducteur de terre (13) à l'aide de l'unité de commande (8), au moins dans l'état d'interruption.

11. Dispositif de surveillance de conducteur de terre selon la revendication 10,
**caractérisé en ce que** le circuit d'évaluation présente au moins un premier dispositif de détection de tension (17) monté entre la connexion de conducteur de terre (13) et la première connexion de potentiel (12) et/ou au moins un deuxième dispositif de détection de tension (16) monté entre la connexion de conducteur de terre (13) et la deuxième connexion de potentiel (11).

12. Dispositif de surveillance de conducteur de terre selon la revendication 11,
**caractérisé en ce que** le premier et/ou le deuxième dispositif de détection de tension (16, 17) est conçu comme un optocoupleur (32, 35) ou présente un optocoupleur (32, 35).

13. Dispositif de surveillance de conducteur de terre selon l'une des revendications précédentes,
**caractérisé en ce que** le dispositif de surveillance de conducteur de terre (7) présente un dispositif d'alimentation électrique (10) qui est conçu pour alimenter au moins l'unité de commande (8) et le dispositif de commutation électrique (14) en énergie électrique nécessaire au fonctionnement, sachant que le dispositif d'alimentation électrique (10) prélève l'énergie électrique dans les première et deuxième connexions de potentiel (11, 12) et la délivre de manière tamponnée au moyen d'un circuit tampon.

14. Dispositif de surveillance de conducteur de terre selon l'une des revendications précédentes,
**caractérisé en ce que** le dispositif de surveillance de conducteur de terre (7) est conçu comme une barrette à bornes (1) ou est disposé dans ou sur une barrette à bornes (1).

15. Programme informatique avec des moyens de code de programme, conçu pour mettre en oeuvre le procédé suivant destiné à surveiller un conducteur de terre faisant office de conducteur de protection d'un appareil électrique mis à la terre au moyen du conducteur de terre, qui fournit de l'énergie électrique et/ou est alimenté en énergie électrique au moyen d'un premier potentiel électrique (0 V), différent du potentiel (PE) du conducteur de terre, et d'un deuxième potentiel électrique (U_{b}), différent du premier potentiel (0 V) et du potentiel (PE) du conducteur de terre, lorsque le programme informatique est exécuté sur un ordinateur :
a) au moins un dispositif de commutation électrique (14) permet de commuter automatiquement, à des intervalles de temps réguliers et/ou irréguliers prédéterminés, entre les états de commutation que sont l'état de liaison et l'état d'interruption, sachant que dans l'état de liaison, une liaison électrique entre le premier potentiel électrique (0 V) et le conducteur de terre est établie au moyen du dispositif de commutation électrique (14), et que dans l'état d'interruption, la liaison électrique entre le premier potentiel électrique (0 V) et le conducteur de terre est interrompue au moyen du dispositif de commutation électrique (14),
b) au moins dans l'état d'interruption, des signaux électriques au niveau du conducteur de terre sont détectés et évalués,
c) à l'aide des signaux électriques évalués au niveau du conducteur de terre, on reconnaît si le conducteur de terre est relié au premier potentiel électrique (0 V) et/ou si le conducteur de terre est relié au deuxième potentiel électrique (U_{b}),
**caractérisé en ce que** l'évaluation des signaux électriques au niveau de la connexion de conducteur de terre (13) est effectuée sans mesurer le courant dans le conducteur de terre.
